# FASCICULE DE BREVET EUROPEEN

(11) **EP 1 393 351 B1**
(45) Date de publication et mention de la délivrance du brevet: **02.11.2011**
(21) Numéro de dépôt: 02730404.7
(22) Date de dépôt: 14.05.2002
(51) Int. Cl.: H01L 21/00, C30B 35/00

(54) **PROCEDE ET DISPOSITIF DE DOPAGE, DIFFUSION ET OXYDATION DE PLAQUETTES DE SILICIUM A PRESSION REDUITE**
VERFAHREN UND VORRICHTUNG ZUM DOTIEREN, DIFFUSION UND OXIDIEREN VON SILIZIUMSCHEIBEN UNTER VERMINDERTEM DRUCK
METHOD AND DEVICE FOR DOPING, DIFFUSION AND OXIDATION OF SILICON WAFERS UNDER REDUCED PRESSURE

(30) Priorité: 14.05.2001 FR 0106863
(43) Date de publication de la demande: 03.03.2004
(73) Titulaire: Semco Engineering S.A., 34196 Montpellier cedex 5 (FR)
(72) Inventeur: PELLEGRIN, Yvon, F-34000 Montpellier (FR)
(74) Mandataire: Ravina, Bernard
(86) Numéro de dépôt international: PCT/FR2002/001620
(87) Numéro de publication internationale: WO 2002/093621

(56) Documents cités:
- US-A1- 2001 000 747
- US-B1- 6 187 102

## Description

La présente invention concerne le dopage du type N et P, la diffusion et l'oxydation des plaquettes de Silicium dans le processus de réalisation de semi-conducteurs.

Dans le processus de fabrication des circuits intégrés pour l'électronique, les technologies de fabrication des semi-conducteurs sont basées principalement sur la modification intrinsèque des atomes du matériau silicium. L'insertion dans la maille du silicium d'éléments à surplus d'électron dit type N et à déficit d'électron dit type P, se définit par le terme de dopage du type N ou du type P.

Pour rendre le silicium semi-conducteur il est nécessaire de lui rajouter des éléments dits dopants. Les éléments dopants connus sont par exemple le Phosphore, l'Arsenic l'Antimoine ou le Bore le Gallium, l'Aluminium.
Dans les procédés les plus utilisés de dopage au Phosphore ou au Bore par exemple, les plaquettes de Silicium sont introduites dans un four et portées à une température comprise généralement entre 800°C et 1200°C. Cette température est nécessaire pour permettre une concentration superficielle du phosphore ou du bore à la surface de la plaquette de silicium.
Les sources de dopants solides, liquides ou gazeux sont vaporisées dans l'enceinte du four à partir d'un gaz porteur en contact avec la source de dopants. Le gaz porteur a pour rôle d'accélérer le dépôt du gaz dopant sur la surface de la plaquette de silicium. Ce type de dépôt s'effectue dans le four à pression atmosphérique. Pour achever la distribution entre les plaquettes, le gaz porteur doit être envoyé avec un grand débit de gaz vecteur, ce qui engendre une importante consommation de gaz.

Les fours horizontaux ou verticaux utilisés ont généralement une enceinte de forme tubulaire dans laquelle les plaquettes de silicium sont disposées sur un support en quartz ou en carbure de silicium. L'une des extrémités de l'enceinte tubulaire est dotée d'une porte pour permettre l'introduction des plaquettes. L'autre extrémité est obturée par une paroi terminale inamovible. Le gaz dopant, le gaz réactif et le gaz vecteur sont généralement injectés au travers d'un orifice pratiqué dans la paroi terminale de l'enceinte tubulaire. Un procédé et un dispositif de dopage et de diffusion de l'etat de l'art est décrit dans le document US 6 187 102 B1.
Pour obtenir une bonne uniformité de traitement il est nécessaire de limiter le nombre de plaquettes dans le four, généralement pas plus de cinquante, et de laisser un espace relativement important entre chaque plaquette.

L'utilisation d'un gaz vecteur pose également des problèmes de condensations importantes d'acide dans le four et l'environnement. Ce dépôt d'acide issu du dopant aura des répercussions sur la répétitivité du traitement de la plaquette mais également sur les différents éléments extérieurs constituants du four ce qui implique des démontages fréquents pour nettoyage du four et notamment du tube en quartz composant l'enceinte de ce dernier.

D'autre part des diffuseurs en quartz, pour améliorer le résultant, sont nécessaires, accentuant les coûts d'exploitation et de gestion des parties en quartz. La remise en fonction après nettoyage nécessite des essais préliminaires entraînant des pertes de capacité productive. D'autres phénomènes comme le manque d'uniformité sur la plaquette, sur charge et de charge à charge, un effet de mémoire de dopage, des inclusions parasites des dopants dans la maille cristallographique du silicium à cause de l'oxygène excédant, des modifications de durées de vies de porteurs minoritaires, la limitation de diamètre des plaquettes sont autant de facteurs obligeant des choix d'équipement plus onéreux.

La présente invention à pour objet de résoudre les problèmes sus évoqués en proposant un nouveau procédé de dopage, de diffusion ou d'oxydation, selon la revendication 1 et un dispositif selon la revendication 9.

Le procédé selon l'invention se caractérise essentiellement en ce qu'il consiste conjointement à l'introduction du gaz dans l'enceinte du four à soumettre cette dernière à une dépression. Cet effet permet d'accroître la vitesse des gaz dans l'enceinte et ne rend plus nécessaire l'emploi de grandes quantités de gaz vecteurs. Seuls les gaz réactifs sont présents dans l'enceinte de dopage du Silicium.

Selon une autre caractéristique de l'invention, la valeur de la dépression est comprise entre 100 et 800 millibars. Cette plage de valeur est compatible avec des moyens relativement simples pour la création de la dépression.

L'invention concerne également une technique d'injection de l'oxygène qui permet de doser avec précision la quantité d'oxygène pour limiter la vitesse du craquage du dopant, c'est-à-dire sa décomposition moléculaire.

L'invention concerne également le dispositif permettant de réaliser une opération de dopage, de diffusion ou d'oxydation des plaquettes. Le dispositif comprend un four pourvu d'une enceinte fermée hermétiquement par une porte, dans laquelle enceinte sont introduites les plaquettes, ledit four comportant au moins une tubulure d'injection d'au moins un gaz dans l'enceinte pour accomplir l'une des opérations susvisées.

Le dispositif tel que défini se caractérise essentiellement en ce qu'il comprend en outre au moins une tubulure d'extraction du gaz, et un moyen d'aspiration connecté à la tubulure d'extraction du gaz, apte à créer dans l'enceinte une dépression constante et contrôlée.

Ainsi, l'utilisation de grandes quantités de gaz vecteur en l'espèce l'azote n'est plus nécessaire en raison de la dépression créée. De plus, la condensation périphérique d'acide est fortement réduite, l'acide étant en grande partie aspiré par le moyen d'aspiration. La condensation résiduelle sera quant à elle récupérée par des dispositifs annexes tels que tuiles et autres.

La présente invention à également pour objet un dispositif de dopage de diffusion ou d'oxydation de plaquettes de silicium comprenant un four pourvu d'une enceinte fermée hermétiquement par une porte, dans laquelle enceinte sont introduites lesdites plaquettes, ledit four comportant au moins une tubulure d'introduction d'au moins un gaz dans l'enceinte pour accomplir les opérations précitées

D'autres avantages et caractéristiques de l'invention apparaîtront à la lecture de la description d'une forme préférée de réalisation, donnée à titre d'exemple non limitatif et illustrée par les dessins joints dans lesquels:

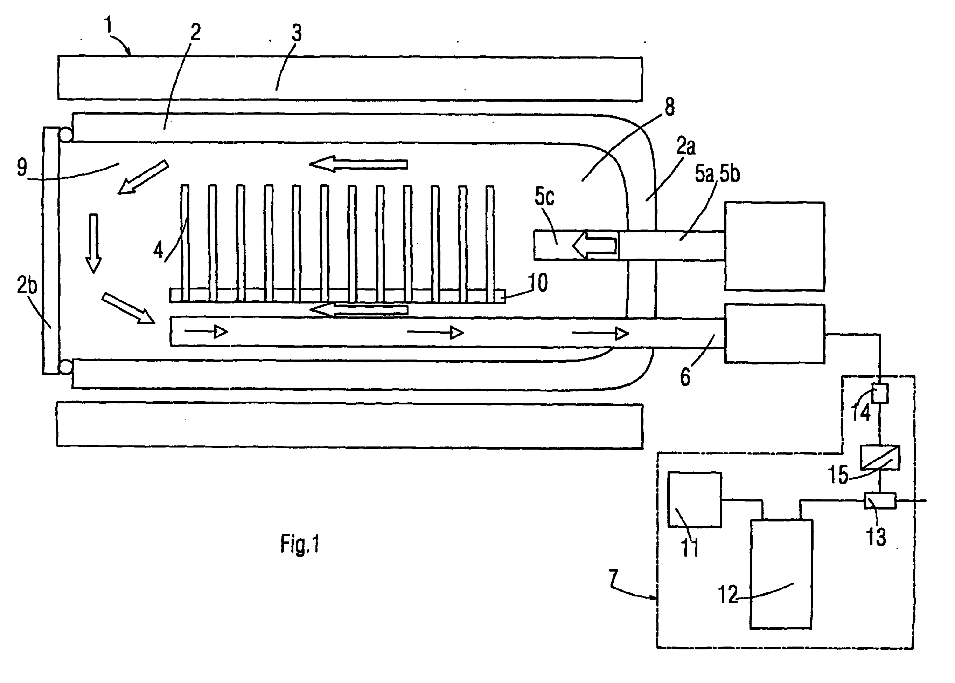

- la figure 1 représente schématiquement le dispositif de dopage de diffusion ou d'oxydation de plaquettes de silicium selon la présente invention,

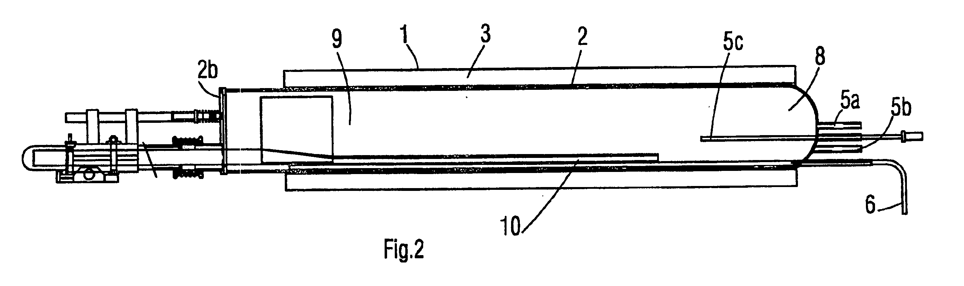

- la figure 2 représente en coupe longitudinale un dispositif de dopage de diffusion ou d'oxydation selon l'invention.

Comme représenté le dispositif de dopage, de diffusion ou d'oxydation de plaquettes de silicium selon l'invention, comprend un four 1 doté d'une enceinte étanche 2 associée à des moyens de chauffage 3, et dans laquelle sont introduites les plaquettes de silicium devant subir l'une des opérations précitées. Le four 1 comporte au moins une tubulure d'introduction 5a, 5b, 5c, d'au moins un gaz dans l'enceinte 2 pour accomplir les opérations précitées et comprend en outre au moins une tubulure 6 d'extraction du gaz, et un moyen d'aspiration 7 connectée à ladite tubulure 6 d'extraction du gaz, apte à créer dans l'enceinte une dépression constante et contrôlée, cette unité d'aspiration étant située à distance du four 1 dans une zone tempérée.

L'enceinte 2, par exemple de forme tubulaire, est fermée hermétiquement par une paroi terminale fixe 2a et par une porte 2b installées à ses extrémités, la porte, en position de fermeture, et la paroi terminale étant normales à l'axe longitudinal de symétrie de l'enceinte tubulaire.

Les moyens de chauffage 3, constitués par exemple par des résistances électriques sont répartis ou enroulés autour de l'enceinte tubulaire et sont disposés à écartement de cette dernière ou bien à son contact.

De préférence, l'enceinte tubulaire 2 présente une section droite en forme de couronne circulaire. Cette disposition confère à la paroi de l'enceinte une bonne résistance mécanique à la pression atmosphérique lorsque le volume interne de l'enceinte est soumis à dépression.

La porte 2b est solidaire d'une monture engagée en coulissement sur un support approprié. Les mouvements de fermeture et d'ouverture de la porte s'effectuent selon l'axe longitudinal de l'enceinte tubulaire. À la porte est associé un fourreau s'étendant vers l'extérieur de l'enceinte dans lequel est montée la queue d'une pelle de chargement des plaquettes. Cette pelle reçoit les supports des plaquettes. Préférentiellement à ce fourreau est associé un moyen de réglage de l'inclinaison de la pelle et ledit fourreau est monté avec une possibilité de déplacement en pivotement autour d'un axe horizontal, normal à l'axe longitudinal de la pelle. Par action sur les moyens de réglage, la pelle, à vide, est plus ou moins inclinée vers le haut, de sorte que lorsqu'elle est chargée elle puisse sensiblement venir se positionner sensiblement selon un plan horizontal. Ce réglage peut être opéré avec un poids sur la pelle, le poids de cette charge correspondant au poids de la charge à traiter.

Préférentiellement, la porte 2b de l'enceinte du four est constituée en quartz opaque ou opacifié et possède un joint d'étanchéité approprié réalisé en une matière à base de d'élastomère fluoré. Une telle matière est notamment connue sous le nom commercial de « VITON ». Une telle matière est notamment fabriquée par la STE DUPONT DE NEMOURS. Le quartz opaque constitue une barrière efficace aux infrarouges, on évite ainsi de brûler le joint d'étanchéité. Pour renforcer encore la protection du joint d'étanchéité, la partie terminale de l'enceinte tubulaire 2 (celle destinée à recevoir la porte 2b) est réalisée en quartz opaque. Dans la pratique cette partie opaque est assemblée à la partie transparente de l'enceinte par tous moyens connus de l'homme de l'art. Dans la forme préférée de réalisation, cet assemblage est réalisé par soudage. Toujours dans le but de renforcer la protection thermique du joint, un écran thermique est disposé dans l'enceinte en regard de la porte.

La porte, par son joint d'étanchéité, est appliquée contre un rebord annulaire que possède la partie terminale opaque de l'enceinte tubulaire, ce rebord annulaire étant également opaque. La face annulaire de ce rebord, en regard du joint de la porte constitue un plan de joint et reçoit le joint en pression. Ce joint est préférentiellement monté dans une gorge annulaire creusée dans la porte 2b. Pour absorber les défauts de parallélisme entre la porte et le plan de joint, ladite porte est montée de manière flottante sur sa monture, c'est-à-dire avec une latitude déplacement limité autour de deux axes sécants et orthogonaux parallèles au plan de joint et le long d'un axe normal à ce plan de joint. Préférentiellement entre la porte et sa monture sont disposés un ou plusieurs organes élastiques et le fourreau comporte une partie axialement déformable.

Pour résister à la chaleur, les parois du four à savoir, la paroi tubulaire de l'enceinte 2 et la paroi terminale 2a sont constituées en quartz. L'enceinte tubulaire pourra être équipée d'une chemise interne en carbure de silicium de forme tubulaire. Cette chemise s'oppose à la déformation radiale vers l'intérieur de l'enceinte tubulaire 2 notamment lorsque cette dernière est soumise à une forte température.

Le trajet des gaz dans l'enceinte 2 du four 1 s'établit depuis une zone amont 8 vers une zone aval 9 située à distance de la précédente, les plaquettes-de silicium 4 étant disposées entre ces deux zones sur le trajet des gaz. Ces plaquettes 4 sont disposées dans l'enceinte 2 du four de manière transversale à la direction d'écoulement des gaz dans cette dernière. Ainsi est créée une perte de charge relativement importante grâce à laquelle les gaz peuvent venir balayer les surface à traiter des plaquettes.

Les plaquettes 4 sont installées sur un support amovible 10 introduit dans l'enceinte 2 du four. Ce support est réalisé en une matière apte à résister tant à la chaleur qu'au pouvoir corrosif des gaz. Ainsi ce support pourra être constitué en carbure de silicium ou bien en quartz. Le support et les plaquettes, après positionnement dans l'enceinte, sont disposés à écartement de la paroi terminale 2a et de la porte 2b, ce qui ménage la zone amont 8, cette dernière étant située entre la paroi terminale 2a et l'emplacement du support de plaquettes, et la zone aval 9 située entre la porte 2b et ledit emplacement, le flux gazeux dans ladite enceinte 2 étant établi entre l'une et l'autre zone et la zone de l'enceinte correspondant à l'emplacement du support de plaquettes de silicium étant la zone la plus chaude de ladite enceinte 2.

La ou les tubulures d'introduction 5a, 5b, 5c du ou des gaz dans l'enceinte 2 du four traversent de part en part la paroi terminale 2a de ce dernier ou la porte 2b et débouchent dans l'une ou l'autre zone amont 8 ou aval 9 de la tubulure d'extraction 6 des gaz traverse de part en part la paroi terminale du four 2a ou la porte 2b et débouche dans l'autre zone amont 8 ou aval 9 de l'enceinte 2. Selon la forme préférée de réalisation, la ou les tubulures 5a, 5b, 5c d'introduction du gaz dans l'enceinte 2 et la tubulure d'extraction 6 du gaz traversent de part en part la paroi terminale 2a de l'enceinte, et les tubulures d'introduction 5a, 5b, 5c du gaz débouchent dans la zone amont 8 de l'enceinte tandis que la tubulure d'extractiony 6 des gaz débouche dans la zone aval 9 de ladite enceinte 2.

L'une des tubulures 5c d'introduction de gaz dans l'enceinte 2 reçoit un gaz réactif en l'espèce de l'oxygène. Avantageusement cette tubulure 5c débouche dans la zone la plus chaude de cette dernière, au plus prés de l'emplacement occupé par le support de plaquettes, pour éviter le craquage anticipé du gaz dopant.

Comme dit précédemment le dispositif selon l'invention est équipé d'une unité 7 d'aspiration des gaz dans l'enceinte 2, apte à y créer en continue une dépression de valeur constante et parfaitement contrôlée. Cette dépression à pour but d'augmenter la vitesse des gaz dans l'enceinte et d'éviter l'emploi de gaz vecteurs.

Selon la forme préférée de réalisation, le moyen d'aspiration 7 comprend notamment une pompe aspirante refoulante 11 avantageusement du type à membrane. Cette pompe 11 au moins pour ses organes en contact avec les gaz sera réalisée en une matière apte à résister à la corrosion des dits gaz. On pourra utiliser une matière constituée à partir de tétrafluoroéthylène. Une telle matière est connue sous le nom commercial de « TEFLON ».

Toujours selon forme préférée de réalisation, l'unité d'aspiration 7 comporte des organes de contrôle et de régulation de la dépression dans l'enceinte du four, ces organes de contrôle et de régulation étant en communication par des conduites d'une part avec la tubulure d'aspiration de la pompe et d'autre part avec la tubulure d'extraction du four.

Les organes de contrôle et de régulation comprennent notamment une capacité de gavage ou ballast, constituée par une chambre cylindrique, connectée par des conduites, d'une part à la tubulure d'aspiration de la pompe et d'autre part à la tubulure 6 d'extraction du four, ladite capacité de gavage 12 étant par ailleurs connectée à une source sous pression de gaz de gavage, contrôlée par l'intermédiaire d'une vanne de contrôle 13, pilotée à l'ouverture et à la fermeture par un circuit de mesure et de contrôle de la dépression dynamique dans l'enceinte 2 du four 1.

Le circuit de mesure et de contrôle de la dépression comprend un capteur de pression 14 disposé à l'extérieur de l'enceinte, sur la conduite de connexion s'étendant entre la capacité de gavage et la tubulure d'extraction du four ou bien sur la capacité de gavage. Ce capteur de pression 14 est apte à produire un signal d'intensité proportionnelle à la valeur de la dépression, ce signal étant appliqué à l'entrée d'un comparateur 15 qui compare la valeur de ce signal à une valeur de consigne. Ce comparateur est connecté par un circuit de puissance à la vanne de contrôle 13 pour, en fonction de l'écart entre la valeur de la dépression et la valeur de consigne, ajuster le degré d'ouverture de l'obturateur de la vanne de contrôle 13 et donc le débit du gaz de gavage ou commander la fermeture de l'obturateur de la vanne contrôle, ce qui permet par gavage plus ou moins prononcé de la pompe ou par absence de gavage d'ajuster à chaque instant la valeur de la dépression dans l'enceinte 2 du four. D'une autre manière, la capacité d'aspiration de la pompe étant constante l'augmentation de débit de gaz de gavage s'accompagne d'une diminution du débit des gaz extraits de l'enceinte du four et inversement.

La capacité de gavage 12 reçoit les gaz de gavage à température ambiante et les gaz chauds extraits de l'enceinte du four. Le mélange des gaz dans cette capacité de gavage entraîne des condensations qui sont récupérées par cette capacité. Ainsi ces condensations ne peuvent en aucune manière perturber le fonctionnement de la pompe 11. La capacité de gavage sera démontable en vue notamment d'extraire ces diverses condensations.

On conçoit que la mesure de la dépression dans l'enceinte du four et le contrôle de cette dernière s'effectuent à l'extérieur du four dans des zones relativement froides et tempérées.

Les gaz rejetés par la pompe sont ensuite neutralisés à l'aide de tous moyens appropriés.

Les avantages de l'invention sont les suivants :
- compatibilité avec la technologie atmosphérique,
- uniformité du traitement sur chaque plaquette, sur chaque charge (ensemble de plaquette sur support), et de charge à charge,
- répétitivité,
- reproductivité après arrêt,
- suppression de l'effet mémoire,
- suppression des overdoses de dopants,
- aucune limitation des diamètres des plaquettes,
- réduction considérable de la maintenance,
- réduction des coûts,
- propreté périphérique,
- fréquence des nettoyages fortement diminuée.

Il va de soi que les enseignements de la présente invention, s'appliquent aussi bien à un four du type horizontal qu'à un four du type vertical.

Il est bien évident que la présente invention peut recevoir tous aménagements et variantes du domaine des équivalents techniques sans pour autant sortir du cadre du présent brevet.

## Revendications

1. Procédé de dopage, de diffusion ou d'oxydation de plaquettes de silicium (4), comprenant les'étapes consistant à :
- installer lesdites plaquettes sur un support et placer celui-ci dans l'enceinte (2) d'un four (1) ferme hermétiquement et chauffé,
- introduire dans l'enceinte les gaz pour accomplir l'opération de dopage, de diffusion ou d'oxydation,
le procédé étant **caractérisé en ce que** sont introduits séparément dans l'enceinte (2) un gaz dopant et un gaz réactif au moins, en l'absence de gaz vecteur, et que conjointement à l'introduction et au passage desdits gaz dans l'enceinte (2), cette dernière est soumise de manière continue à une dépression de valeur constante.

2. Procédé selon la revendication 1, **caractérisé en ce que** le trajet des gaz s'établit depuis une zone amont (8) située entre la paroi terminale (2a) et l'emplacement du support des plaquettes, vers une zone aval (9) de l'enceinte (2) située entre la porte (2b) et ledit emplacement, les plaquettes (4) étant disposées de manière transversale entre lesdites zones amont et aval, correspondant à lei partie la plus chaude de ladite enceinte.

3. Procédé selon la revendication 1 ou 2, **caractérisé en ce que** les gaz sont introduits dans la zone amont (8) de l'enceinte à travers la paroi terminale (2) de l'enceinte, et les gaz sont extraits à partir de la zone aval (9) de l'enceinte (2) à travers la paroi terminale (2a) du four.

4. Procédé selon l'une des revendications précédentes, **caractérisé en ce que** ledit gaz réactif est introduit par une tubulure dans la zone la plus chaude de l'enceinte, à proximité de l'emplacement occupé par le support des plaquettes, pour éviter le craquage anticipé du gaz dopant.

5. Procédé selon l'une des revendications précédentes, **caractérisé en ce que** la valeur de la dépression dans l'enceinte du four est comprise entre 100 et 800 millibars.

6. Procédé selon l'une des revendications précédentes, **caractérise en ce que** les gaz sont extraits de l'enceinte par aspiration à l'aide d'une pompe aspirante refoular te (11), du type pompe à membrane.

7. Procédé selon l'une des revendications précédentes, **caractérisé en ce que** la dépression dans l'enceinte (2) est contrôlée et régulée par un circuit de mesure et de contrôle de la dépression piloté à l'ouverture et à la fermeture par une vanne de contrôle (13) d'une source de gaz sous pression reliée à une capacité de gavage (12) placée entre la l'enceinte (2) et la pompe (11).

8. Procédé selon la revendication précédente, **caractérisé en ce que** la mesure et le contrôle de la dépression sont réalisés par un capteur de pression (14) disposé à l'extérieur de l'enceinte (2), sur la conduite de connexion s'étendant entre la capacité de gavage et la tubulure d'extraction du four, ledit capteur (14) de pression étant apte à produire un signal d'intensité proportionnelle à la valeur de la dépression, ledit signal étant appliqué à l'entrée d'un comparateur (15) qui compare la valeur de ce signal à une valeur de consigne, ledit comparateur étant connecté par un circuit de puissance à la vanne de contrôle pour, en fonction de l'écart entre la valeur de la dépression et la valeur de cons gne, ajuster le degré d'ouverture de l'obturateur de la vanne (13) ou commander la fermeture de l'obturateur de la vanne de contrôlée (13) ce qui permet par gavage plus ou moins prononcé de la pompe (11) ou par absence de gavage d'ajuster à chaque instant la valeur de la dépression dans l'enceinte (2) du four.

9. Dispositif de dopage, de diffusion ou d'oxydation de plaquettes de silicium (4) pour la mise en oeuvre du procédé selon l'une des revendications précédentes, comprenant :
- un four (1) doté d'une enceinte (2) associée à des moyens de chauffage (3) et fermée hermétiquement par une porte (2b), ledit four comportant un emplacement pour l'introduction dans ladite enceinte d'un support amovible (10) sur lequel les plaquettes (4) sont installées, ce qui ménage une zone amont (8) située entre la paroi terminale (2a) et ledit support de plaquettes, et une zone aval (9) située entre la porte (2b) et ledit support.
- la paroi terminale (2a) dudit four comportant des tubulures (5a, 5b, 5c) d'introduction séparée d'un gaz dopant et d'un gaz réactif au moins dans l'enceinte (2), en l'absence d'entrée de gaz vecteur, et une tubulure (6) d'extraction des gaz connectée à une unité d'aspiration (7) desdits gaz, ladite unité d'aspiration comportant des organes de contrôle et de régulation de la dépression dans l'enceinte du four, de manière à créer dans l'enceinte (2) une dépression constante et contrôlée induisant un flux contrôlé et stabilisé des gaz

10. Dispositif selon la revendication 9, **caractérisé en ce que** les tubulures (5a, 5b, 5c) d'introduction des gaz dans l'enceinte du four traversent de part en part la paroi terminale (2a) de l'enceinte (2) du four et débouchent dans la zone amont (8), et que la tubulure d'extraction (6) des gaz traverse de part en part la paroi terminale (2 a) du four et débouche dans la zone aval (9) de l'enceinte (2), de sorte que le trajet des gaz dans l'enceinte s'établit depuis la zone amont vers la zone aval de l'enceinte.

11. Dispositif selon l'une des revendications 9 ou 10, **caractérisé en ce qu**'il comprend une tubulure d'introduction (5c) de gaz réactif dans l'enceinte (2) débouchant à proximité de l'emplacement occupé par le support de plaquettes.

12. Dispositif selon l'une des revendications 9 à 11, **caractérisé en ce que** l'unité d'aspiration comprend une pompe aspirante refoulante (11), du type pompe à membrane.

13. Dispositif selon la revendication précédente, **caractérisé en ce que** la pompe (11), au moins pour ces organes en contact avec les gaz, est réalisée en une matière apte à résister à la corrosion des dits gaz.

14. Dispositif selon la revendication 12, **caractérisé en ce que** l'unité d'aspiration (7) comporte des organes de contrôle et de régulation de la dépression dans l'enceinte du four, ces organes de contrôle et de régulation étant en communication par des conduites, d'une part avec la tubulure d'aspiration de la pompe, et d'autre part avec la tubulure d'extraction (6) du four.

15. Dispositif selon la revendication précédente, **caractérisé en ce que** les organes de contrée et de régulation comprennent une capacité de gavage (12) ou ballast, connectée par des conduites, d'une part à la tubulure d'aspiration de la pompe (11) et d'autre part à la tubulure (6) d'extraction des gaz de l'enceinte du four, ladite capacité de gavage (12) étant par ailleurs connectée à une source de gaz sous pression contrôlée par l'intermédiaire d'une vanne de contrôle (13) pilotée à l'ouverture et à la fermeture par un circuit de mesure et de contrôle de la dépression dans l'enceinte (2) du four (1).

16. Dispositif selon la revendication précédente, **caractérisé en ce que** le circuit de mesure et de contrôle de la dépression comprend un capteur de pression (14) disposé à l'extérieur de l'enceinte (2), sur la conduite de connexion s'étendant entre la capacité de gavage et la tubulure d'extraction du four, ledit capteur (14) de pression étant relié à un comparateur (15) connecté par un circuit de puissance à la vanne de contrôle.

17. Dispositif selon l'une quelconque des revendications 9 à 16, **caractérisé en ce que** l'enceinte (2) du four (1) est de forme tubulaire, avec une section droite en forme de couronne circulaire.

18. Dispositif selon l'une quelconque des revendications 9 à 17, **caractérisé en ce que** les parois du four sont en quartz, et que l'enceinte tubulaire reçoit un chemisage interne en carbure de silicium.

19. Dispositif selon l'une quelconque des revendications 9 à 18, **caractérisé en ce que** la porte (2b) et la paroi terminale (2a) de l'enceinte du four sont en quartz opaque.

20. Dispositif selon l'une quelconque des revendications 9 à 19, **caractérisé en ce que** la porte est solidaire d'une monture engagée en coulissement sur an support et que ladite porte est montée de manière flottante sur sa monture c'est-à-dire avec une latitude de déplacement limité autour de deux axes sécants et orthogonaux parallèles au plan de joint de la porte avec l'enceinte et le long d'un axe normal à ce plan de joint.

## Claims

1. Process for doping, diffusion or oxidation of silicon wafers (4), comprising the steps of :
- placing said wafers on a support and introducing said support into the chamber (2) of an oven (1) hermetically sealed and heated,
- introducing into the chamber the gases to accomplish the operation of doping, diffusion or oxidation,
said process being **characterized in that** a doping gas and a reacting gas at least are introduced separately into the chamber (2), to the exclusion of vector gas, and that simultaneously to the introduction and to the passage of said gases into the chamber (2), this latter is subjected, continuously, to an under-pressure of constant value.

2. Process according to claim 1, **characterized in that** the gases flow from an upstream region (8) located between the end wall (2a) and the position of the wafer support to a downstream region (9) of the chamber (2) located between the door (2b) and said position, the wafers (4) being placed perpendicularly between said upstream and downstream region, corresponding to the hottest region in said chamber.

3. Process according to claim 1 or 2, **characterized in that** the gases are introduced into the upstream region (8) of the chamber through the end wall of the oven chamber (2), and the gases are extracted from the downstream region (9) of the chamber (2) through the end wall (2a) of the oven.

4. Process according to one of the preceding claims, **characterized in that** the reactive gas is introduced into the warmest zone of the chamber (2) through a tube, nearest the position occupied by the wafer support, to avoid anticipated cracking of the doping gas.

5. Process according to one of the preceding claims, **characterized in that** the value of the pressure in the oven chamber is comprised between 100 and 800 millibars.

6. Process according to one of the preceding claims, **characterized in that** the gases are extracted from the chamber by suction with a suction force pump (11) of the membrane type.

7. Process according to one of the preceding claims, **characterized in that** the pressure in the chamber (2) is controlled and regulated by a circuit for measurement and control of the under-pressure, controlled for the opening and closing by means of a valve (13) controlling a source of pressurized gas connected to an over-pressure capacity (12) placed between the chamber (2) and the pump (11).

8. Process according to the preceding claim, **characterized in that** the measurement and control of the pressure are effected by a pressure detector (14) disposed outside the chamber (2), in the connection conduit extending between the over pressure capacity and the withdrawal tube from the oven, said pressure detector (14) being adapted to produce a signal of an intensity proportional to the value of the actual pressure, said signal being applied to the inlet of a comparator (15) which compares the value of this signal to a reference value, said comparator being connected by a power circuit to the control valve for, as a function of the gap between the actual pressure value and the reference value, adjusting the degree of opening of the control valve (13) or controlling the closing of the control valve (13) which permits by more or less pronounced feeding up of the pump (11) or by the absence of feeding up to adjust at each instant the value of the pressure in the chamber (2) of the oven.

9. Device for carrying out a process for doping, diffusion or oxidation of silicon wafers (4) according to one of the preceding claims, comprising:
- an oven (1) provided with a chamber (2) associated with heating means (3) and hermetically sealed by a door (2b), said oven comprising an emplacement for introduction into said chamber of a removable support (10) on which said wafers (4) are placed, that defines an upstream region (8) located between the end wall (2a) and said wafer support, and a downstream region (9) located between the door (2b) and said wafer support,
- said end wall (2a) of the oven comprising inlet tubes (5a, 5b, 5c) for separate introduction of a doping gas and a reacting gas at least, into the chamber (2), in the absence of means for introduction of vector gas, and one tube (6) for the withdrawal of the gases, connected to a suction unit (7) of said gases, the latter suction unit having means for controlling and regulating the pressure in the oven chamber, adapted to create in the chamber (2) a constant and controlled under-pressure, and yielding to a stable and controlled flow of gases.

10. Device according to claim 9, **characterized in that** the inlet tubes (5a, 5b, 5c) for introduction of gases into the oven chamber pass through the end wall (2a) of the chamber (2) of the oven and open into the upstream region (8), and that the withdrawal tube (6) for the gases passes through the end wall (2a) of the oven and opens into the downstream region (9) of the chamber (2), so that the gases flow in the chamber from the upstream region to the downstream region of the chamber.

11. Device according to one of claims 9 or 10, **characterized in that** it comprises an introduction tube (5c) of the reactive gas into the chamber (2) opening nearest the position occupied by the wafers.

12. Device according to one of claim 9 to 11, **characterized in that** the suction unit comprises a suction force pump (11) of the membrane type.

13. Device according to the preceding claim, **characterized in that** the pump (11) at least as to its parts in contact with the gases, is made of a material adapted to resist corrosion by said gases.

14. Device according to claim 12, **characterized in that** the suction means (7) comprise control and regulation members for the pressure in the oven chamber, these control and regulation members being in communication by conduits with on the one hand the suction tube of the pump, and on the other hand with the withdrawal tube (6) of the oven.

15. Device according to the preceding claim, **characterized in that** the control and regulation members comprise an over-pressure or ballast capacity (12), connected by conduits, on the one hand to the suction tube of the pump (11) and on the other hand to the extraction tube (6) of the gases from the oven chamber, said over-pressure capacity (12) being moreover connected to a source of pressurized gas controlled by means of a control valve (13) for the opening and closing by a measurement and control circuit of the under-pressure in the chamber (2) of the oven (1).

16. Device according to the preceding claim, **characterized in that** the measuring and control circuit for the under-pressure comprises a pressure detector (14) disposed outside the chamber (2), on the connection conduit extending between the over-pressure capacity and the extraction tube (6) from the oven, said pressure detector (14) being connected to a comparator (15), said comparator being connected by a power circuit to the control valve.

17. Device according to any one of claims 9 to 16, **characterized in that** the chamber (2) of the oven (1) is of tubular shape, with a cross-section in the shape of a circular crown.

18. Device according to any one of claims 9 to 17, **characterized in that** the walls of the oven are constituted of quartz, and the tubular chamber receives an internal cladding of silicon carbide.

19. Device according to any one of claims 9 to 18, **characterized in that** the door (2b) and the end wall (2a) of the oven chamber are made of opaque quartz.

20. Device according to any one of claims 9 to 19, **characterized in that** the door is secured to a mounting engaged slidably on a support and that said door is mounted floatingly on the mounting, which is to say with a limited latitude of movement about two secant and orthogonal axes parallel to the joint plane of the door with the chamber and along an axis normal to this joint plane.

## Patentansprüche

1. Verfahren zur Dotierung, Diffusion oder Oxydation von Silzium-Wafern (4), das die Verfahrensschritte aufweist, welche darin bestehen,
- dass man die genannten Silizium-Wafer auf einem Träger anordnet und diesen in der Kammer (2) eines Ofens (1), welcher hermetisch abgedichtet und beheizt ist, anordnet,
- dass man in diese Kammer (2) die Gase einbringt, um den Arbeitsgang des Dotierens, der Diffusion oder der Oxydation auszuführen,
- das Verfahren ist dadurch charakterisiert, dass separat in die Kammer (2) zumindest ein dotierendes Gas und ein reaktives Gas, bei Abwesenheit eines Vektorgases, eingeführt werden, und dass gemeinsam mit der Einleitung und Passage dieser Gase in und durch die Kammer (2), die Kammer auf kontinuierliche Art und Weise einem Unterdruck mit einem konstanten Wert ausgesetzt wird.

2. Verfahren nach Anspruch 1, **dadurch gekennzeichnet, dass** der Weg der Gase sich von einer Stromaufwärtszone (8), die zwischen der Endwand (2a) und dem Platz des Trägers der Silizium-Wafer angeordnet ist, zu einer Stromabwärtszone (9) der Kammer (2) einstellt, die zwischen der Tür (2b) und dem genannten Platz angeordnet ist, die Silizium-Wafer (4) sind dabei zwischen der Stromaufwärtszone (8) und der Stromabwärtszone (9), was dem heißesten Bereich der Kammer (2) entspricht, quer angeordnet.

3. Verfahren nach Anspruch 1 oder 2, **dadurch gekennzeichnet, dass** die Gase in die Stromaufwärtszone (8) der Kammer (2) durch die Endwand (2) der Kammer (2) eingelassen werden, und dass die Gase von der Stromabwärtszone (9) der Kammer (2) durch die Endwand (2a) des Ofens (1) abgeführt werden.

4. Verfahren nach einem der vorangegangenen Ansprüche, **dadurch gekennzeichnet, dass** das reaktive Gas durch ein Rohr in die heißeste Zone des Ofens (1) eingeleitet wird, und zwar in Nähe des Platzes, der von dem Träger der Silzium-Wafern (4) eingenommen wird, um einen vorzeitigen Crackingprozess des dotierenden Gases zu vermeiden.

5. Verfahren nach einem der vorangegangenen Ansprüche, **dadurch gekennzeichnet, dass** der Wert des Unterdrucks in der Kammer (2) des Ofens (1) zwischen 100 und 800 Millibar liegt.

6. Verfahren nach einem der vorangegangenen Ansprüche, **dadurch gekennzeichnet, dass** die Gase aus der Kammer (2) durch Ansaugen mittels einer Saugpumpe (11) vom Typ einer Membranpumpe erfolgt.

7. Verfahren nach einem der vorangegangenen Ansprüche, **dadurch gekennzeichnet, dass** der Unterdruck in der Kammer (2) kontrolliert und geregelt wird mittels einer Mess- und Steuerschaltung für den Unterdruck, die gesteuert wird zu einem Öffnen oder Schließen durch ein Steuerventil (13) für eine unter Druck stehende Gasquelle, die an eine Aufladungskapazität (12) angeschlossen ist, welche zwischen der Kammer (2) und der Pumpe (11) angeordnet ist.

8. Verfahren nach dem vorangegangenen Anspruch, **dadurch gekennzeichnet, dass** die Erfassung und Regelung des Unterdrucks mittels eines Druckfühlers (14) erfolgt, der außerhalb der Kammer (2) und an der Verbindungsleitung, die sich zwischen der Aufladungskapazität und dem Ableitungsrohr des Ofens (1) erstreckt, angeordnet ist, der Druckfühler (14) ist dafür ausgelegt, ein Signal mit einer dem Wert des Unterdrucks proportionalen Höhe zu liefern, dieses Unterdrucksignal wird an den Eingang eines Komparators (15) angelegt, der den Wert dieses Unterdrucksignals mit einem vorgegebenen Wert vergleicht, der Komparator (15) ist mittels eines Leistungskreises mit dem Steuerventil (13) verbunden, um in Abhängigkeit von der Abweichung zwischen dem Wert des Unterdrucksignals und dem vorgegebenen Wert, das Maß der Öffnung des Schließteils des Steuerventils (13) oder das Schließen des Schließteils des Steuerventils (13) einzustellen, dies ermöglicht es, durch mehr oder weniger starke Aufladung der Pumpe (11) oder Abwesenheit der Aufladung in jedem Augenblick den Wert des Unterdrucks in der Kammer (2) des Ofens (1) einzustellen.

9. Vorrichtung zur Dotierung, Diffusion oder Oxydation von Silzium-Wafern (4) für die Durchführung des Verfahrens nach einem der vorangegangenen Ansprüche, aufweisend:
- einen Ofen (1), der mit einer Kammer (2) versehen ist, welcher Heizmittel (3) zugeordnet sind und die hermetisch durch eine Tür (2b) abgeschlossen ist, der Ofen (1) weist einen Platz für das Einbringen eines beweglichen Trägers (10), auf dem die Silizium-Wafer (4) angeordnet sind, in die Kammer (2) auf, was zu einer Stromaufwärtszone (8), die zwischen der Endwand (2a) und dem Träger der Silizium-Wafer (4) angeordnet ist, und einer Stromabwärtszone (9), die zwischen der Tür (2b) und dem Träger angeordnet ist, führt,
- die Endwand (2a) des Ofens weist Rohre (5a, 5b, 5c) für die separate Einleitung zumindest eines dotierenden Gases und eines reaktiven Gases in die Kammer (2), bei Abwesenheit eines Vektorgases, und ein Ableitungsrohr (6) für das Abführen der Gase, das an eine Saugeinheit (7) für diese Gase angeschlossen ist, auf, diese Saugeinheit weist Mittel für die Steuerung und Regelung des Unterdrucks in der Kammer (2) des Ofens (1) auf, so dass in der Kammer (2) ein konstanter und kontrollierter Unterdruck hervorgerufen wird, der einen kontrollierten und stabilisierten Fluss der Gase bewirkt.

10. Vorrichtung nach Anspruch 9, **dadurch gekennzeichnet, dass** die Rohre (5a, 5b, 5c) für die Einleitung der Gase in die Kammer (2) des Ofens (1) die Endwand (2a) der Kammer (2) des Ofens (1) von der einen zur anderen Seite durchsetzen und in der Stromaufwärtszone (8) münden, und dass das Ableitungsrohr (6) der Gase die Endwand (2a) des Ofens (1) von der einen zur anderen Seite hin durchsetzt und in der Stromabwärtszone (9) der Kammer (2) mündet, dergestalt, dass der Weg der Gase in der Kammer (2) sich von der Stromaufwärtszone (8) zur Stromabwärtszone (9) der Kammer (2) einstellt.

11. Vorrichtung nach einem der Ansprüche 9 oder 10, **dadurch gekennzeichnet, dass** sie ein Einleitungsrohr (5c) für das reaktive Gas in die Kammer (2) aufweist, das in Nähe des Platzes, der vom Träger der Silizium-Wafer (4) belegt ist, mündet.

12. Vorrichtung nach einem der Ansprüche 9 bis 11, **dadurch gekennzeichnet, dass** die Saugeinheit (7) eine ansaugende Verdrängerpumpe (11) vom Typ einer Membranpumpe aufweist.

13. Vorrichtung nach dem vorangegangenen Anspruch, **dadurch gekennzeichnet, dass** die Pumpe (11), zumindest soweit die in Kontakt mit den Gasen kommenden Teile betroffen sind, aus einem Material hergestellt ist, das einer Korrosion durch diese Gase widerstehen kann.

14. Vorrichtung nach Anspruch 12, **dadurch gekennzeichnet, dass** die Saugeinheit (7) Organe für die Steuerung und Regelung des Unterdrucks im Ofen (1) aufweist, diese Organe für die Steuerung und Regelung stehen über Leitungen in Kommunikation einerseits mit dem Ansaugrohr der Pumpe (11) und andererseits mit dem Ableitungsrohr (6) des Ofens.

15. Vorrichtung nach dem vorangegangenen Anspruch, **dadurch gekennzeichnet, dass** die Organe für die Steuerung und Regelung eine Aufladungs- oder Ballastkapazität (12) aufweisen, die über Leitungen einerseits mit dem Ansaugrohr der Pumpe (11) und andererseits mit dem Ableitungsrohr (6) für die Gase aus der Kammer (2) des Ofens (1) verbunden ist, diese Aufladungskapazität (12) ist zudem mittels eines Steuerventils (13), das durch eine Mess- und Steuerschaltung für den Unterdruck in der Kammer (2) des Ofens (1) zu einem Öffnen und einem Schließen veranlasst wird, mit einer unter kontrolliertem Druck stehenden Gasquelle verbunden.

16. Vorrichtung nach dem vorangegangenen Anspruch, **dadurch gekennzeichnet, dass** die Mess- und Steuerschaltung für den Unterdruck einen Druckfühler (14) aufweist, der außerhalb der Kammer (2) an einer Verbindungsleitung angeordnet ist, die sich zwischen der Aufladungskapazität und dem Ableitungsrohr des Ofens befinden, dieser Druckfühler (14) ist mit einem Komparator (15) verbunden, der über einen Leistungskreis mit dem Steuerventil (13) verbunden ist.

17. Vorrichtung nach einem beliebigen der Ansprüche 9 bis 16, **dadurch gekennzeichnet, dass** die Kammer (2) des Ofens (1) rohrförmig ist und einen Querschnitt in Form eines kreisförmigen Kranzes aufweist.

18. Vorrichtung nach einem beliebigen der Ansprüche 9 bis 17, **dadurch gekennzeichnet, dass** die Wände des Ofens (1) aus Quarz sind, und dass der rohrförmige Ofen (1) eine innere Auskleidung aus Siliziumcarbid aufweist.

19. Vorrichtung nach einem beliebigen der Ansprüche 9 bis 18, **dadurch gekennzeichnet, dass** die Tür (2b) und die Endwand (2a) der Kammer (2) des Ofens (1) aus opakem Quarz sind.

20. Vorrichtung nach einem beliebigen der Ansprüche 9 bis 19, **dadurch gekennzeichnet, dass** die Tür mit einer Halterung verbunden ist, die auf einem Träger verschiebbar ist, und dass die Tür an ihrer Halterung schwimmend angebracht ist, d.h. mit einer begrenzten seitlichen Verschiebbarkeit um zwei einander schneidende und zueinander orthogonale Achsen, die parallel zur Ebene der Dichtung der Tür mit der Kammer (2) verlaufen und längs zu einer zu dieser Dichtungsebene normalen Achse sind.
